# EUROPEAN PATENT SPECIFICATION

(11) **EP 1 442 509 B1**
(45) Date of publication and mention of the grant of the patent: **22.06.2005**
(21) Application number: 02703814.0
(22) Date of filing: 18.03.2002
(51) Int. Cl.: H01S 5/0625

(54) **STABILITY FACTORS FOR TUNEABLE MULTI-SECTION SEMICONDUCTOR LASERS**
STABILITÄTSFAKTOREN FÜR DURCHSTIMMBARE HALBLEITERLASER MIT MEHREREN SEKTIONEN
FACTEURS DE STABILITE DE LASERS A SEMI-CONDUCTEURS MULTISECTIONS ACCORDABLES

(30) Priority: 30.10.2001 IE 20010954
(43) Date of publication of application: 04.08.2004
(73) Proprietor: Tsunami Photonics Limited, Dun Laoghaire, Co. Dublin (IE)
(72) Inventor: O'GORMAN, Neal, Tsunami Photonics Limited, Dun Laoghaire, Co. Dublin (IE)
(74) Representative: Want, Clifford James
(86) International application number: PCT/IB2002/000787
(87) International publication number: WO 2003/038954

(56) References cited:
- EP-A- 0 529 732
- EP-A- 1 130 725
- WO-A-00/54380
- WO-A-01/28052
- WO-A-99/40654
- US-A- 6 064 681
- WOODWARD S L ET AL: "A CONTROL LOOP WHICH ENSURES HIGH SIDE-MODE-SUPPRESSION RATIO IN A TUNABLE DBR LASER" IEEE PHOTONICS TECHNOLOGY LETTERS, IEEE INC. NEW YORK, US, vol. 4, no. 5, 1 May 1992 (1992-05-01), pages 417-419, XP000272629 ISSN: 1041-1135

## Description

This invention relates to stability factors for tuneable multi-section semiconductor lasers.

Tuneable semiconductor laser are used in, for example, telecommunications optical networks to transmit data on specified wavelength channels in a wavelength division multiplexed system. The efficient generation of a look-up table (LUT) necessary to control the tuning of a multi-section laser for such an application is known from, for example, WO01/28052. The look-up table stores values of parameters for controlling currents supplied to respective sections of the multi-section laser for which values the laser will operate stably remote from mode boundaries to emit radiation at a required frequency. There is a requirement for measurement of a quality control parameter of such lasers. Moreover, as the laser ages, or otherwise is degraded, the position of the mode boundaries may change with respect to the controlling currents, so that the laser becomes unstable by becoming subject to mode jumping and hence frequency hopping. Known methods of monitoring lasers after installation to ensure that they continue to operate stably involve long periods of downtime.

It is an object of the present invention at least partially to mitigate the foregoing disadvantages.

According to the present invention there is provided a method of characterising a tuneable multi-section semiconductor laser comprising the steps of a) applying currents in step-wise increments to sections of the laser respectively; b) measuring power output by the laser to determine values of the applied currents corresponding to respective stable operating conditions for which the laser emits radiation at wavelengths remote from mode boundaries of the laser; c) determining the respective wavelength of the emitted radiation; d) measuring variations in the applied currents required to cross a mode boundary such that the laser emits at a wavelength different from that under the respective stable operating condition; and e) storing in a look-up table respective values of applied currents for which the laser emits radiation at wavelengths remote from mode boundaries, the corresponding wavelengths of the radiation and the variations in applied currents required to cross adjacent mode boundaries.

Conveniently, step a) comprises applying currents in step-wise increments using a programmed waveform.

Conveniently, the programmed waveform has a frequency of 100 kHz.

Preferably, the programmed waveform has a frequency of 1MHz.

Conveniently, step d) of measuring the variations comprises deriving the variations by determining distances in an applied current plane of a point corresponding to the stable operating condition from adjacent longitudinal and super-mode boundaries.

Advantageously, the stored variations are normalised.

Conveniently, the multi-section semiconductor laser has front, gain, phase and back sections and step a) includes the steps of a1) applying constant currents to the gain and phase sections such that the laser emits laser radiation; a2) applying back and front currents in step-wise increments to the back and front sections respectively; and step e) includes storing in a look-up table the values of front and back current for which the laser emits radiation at wavelengths remote from mode boundaries.

Advantageously, step c) includes step c1) providing an optical filter for transmitting a proportion of power of an incident light beam emitted by the laser, the proportion being dependant on the wavelength of the incident light beam; and step c2) measuring the proportion of power transmitted by the filter to determine the wavelength of the emitted radiation.

Conveniently, step a) comprises holding the front current at a first front constant and varying the back current, holding the front current at a second front constant and varying the back current, holding the back current at a first back constant and varying the front current, holding the back current at a second back constant and varying the front current, and increasing the front current from a third front constant to a fourth front constant while decreasing the back current from a third back constant to a fourth back constant in order to determine stable middle lines within each super-mode and wherein, having determined the stable middle lines, subsequent steps of varying the back current and/or the front current respectively comprise varying the respective current through a window of a plurality of incremental values along the stable middle lines and determining for which of the plurality of incremental values the power output is a minimum, and repeatedly incrementing each of the plurality of incremental values and re-determining the current value corresponding to the minimum output power within the window to determine a current value corresponding to a local minimum in the power output.

Conveniently the method includes the further step of increasing the front current and decreasing the back current to determine further stable points along further diagonal lines of measurement parallel to the first diagonal line of measurement to generate a mode map for display on a visual display.

Advantageously, step b) comprises determining midpoints between the current values corresponding to local minima in the power output to obtain stable middle points of operation of the laser and step e) includes storing data representative of such stable middle points together with the corresponding wavelength of emitted laser light in the look-up table and wherein operational conditions for operating the frequencies between the stable middle point frequencies are determined by determining and storing in the look-up table the required values of phase current injected into the phase section of the laser and wherein the required values of phase current are determined by holding the back and front currents constant successively at a first stable point and incrementing the phase current until a frequency of laser emission corresponding to a next stable point is reached and calculating what increments of phase current are required to step from the first stable point to the second stable point in desired frequency increments.

Conveniently, the method comprises the further step of f) measuring the variations in the applied currents at predetermined intervals of time to determine new values of the variations; and g) comparing the new values with previously determined values of the variations to determine whether any change in the values is sufficient to require re-characterisation of the laser.

Advantageously, step g) comprises comparing the new values with values stored in the look-up table when the laser was last characterised.

Conveniently, the step of determining whether any change in the values is sufficient to require re-characterisation of the laser comprises determining whether the variations are greater than a predetermined value or represent more than a predetermined percentage change.

A specific embodiment of the invention will now be described by way of example with reference to the accompanying drawings, in which:
Figure 1 is a schematic side view of an apparatus for characterising a multi-section semiconductor laser suitable for use in the present invention;
Figure 2 shows a plot, useful in understanding the method of the invention, of current injected in a front section and current injected in a back section of a multi-section laser showing a stable middle line between two super-mode boundaries;
Figure 3 shows a graph, useful in understanding the method of the invention, of current injected in a front section of the laser of Figure 1 as abscissa versus current injected in a back section of the laser of Figure 1 as ordinates, to determine the positions of stable middle lines such as that shown in Figure 2;
Figure 4 shows a graph of power output of the laser of Figure 1 along a stable middle line between mode boundaries such at that shown in Figure 2, with distance along the middle line as abscissa and power emitted as ordinates;
Figure 5 shows a plot derived from Figure 4, of stable operating positions between super-mode and longitudinal mode boundaries for the laser of Figure 1;
Figure 6 shows a detail of Figure 5, showing diagrammatically the location of stable operating points between super-mode and longitudinal mode boundaries;
Figure 7 shows an operating point of Figure 6 after ageing of the laser; and
Figure 8 shows a graph of frequencies as ordinates vs supermode number as abscissa used in a quality control embodiment of the invention.

In the figures, like reference numerals refer to like parts.

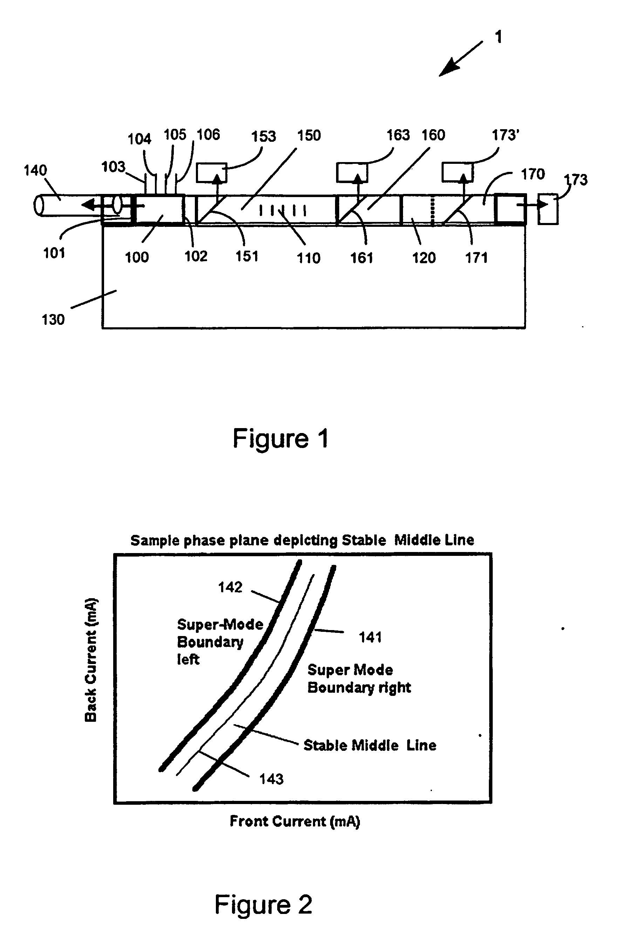

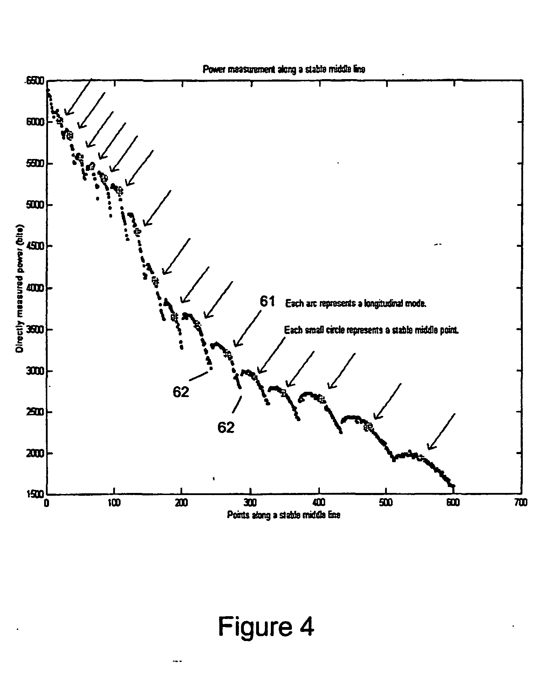

Referring to Figure 1, there is shown a schematic side view of an optoelectronic device 1 as disclosed in WO01/28052 for characterising a multi-section laser 100. As shown in Figure 1, the multi-section laser 100, a long period grating, or feature extraction filter, 110, and a Fabry Perot etalon 120 are serially located on a silicon substrate 130. Alternatively, a silicate or silicate-on-silicon substrate may be used. A long period grating is a grating in which corrugations or "lines" are sufficiently widely spaced that a transmission or reflection spectrum generated by the grating is sufficiently broad to give a monotonic variation with wavelength over, for example, the C-Band or L-Band, or both, for optical fibre networks. The grating may alternatively be incorporated in an optical fibre or a dielectric filter producing a similar monotonic transmission spectrum. The laser may be, for example, a known four-section InGaAsP sampled grating distributed Bragg reflector (SG-DBR) laser or a gain coupled sampled grating reflector (GCSR) laser. In the latter case one grating section is a middle section, the coupler. Alternatively, a superstructure SG-DBR (SSG-DBR) laser may be used. The invention is also applicable to, for example, a five-section laser, the fifth section being a semiconductor optical amplifier to provide a higher power output. The invention is also applicable to, for example, a three-section laser rather than a four-section or five-section laser. An electro-absorption modulator (EAM) may be monolithically integrated, or hybridised with the laser to provide data modulation of the laser output.

Rather than being connected to the inline, hybridised Fabry Perot etalon, the output of the long period grating, or feature extraction filter, may be connected to an external frequency locker, not shown.

Input leads 103,104,105,106 are provided for injecting currents into the sections of the laser respectively. A first output facet 101 of the laser is optically connected to an output optical fibre 140. The optical fibre may be located in a V-groove in the silicon substrate for ease of positioning in relation to the laser.

A second facet 102 of the laser, opposed to the first facet, (or beam split light from the first facet 101 in the case of a GCSR) is optically connected by a first integrated optical waveguide 150 to the long period grating, or feature extraction filter, 110. The waveguide may be, for example, silicate glass on silicate substrate. Alternatively, the waveguide layer may be another glass, or silicon or another semiconductor. The waveguide layer may be deposited on silicate, glass, silicon or another semiconductor substrate. Within the integrated optical waveguide there is located a first beam splitter 151 for diverting a proportion of the light emitted from the second facet 102 of the laser towards a first photodiode 153. The photodiode may be a known InGaAs photodiode.

In an alternative application of the invention, the laser, waveguide and photodiodes may form a monolithic device in a semiconductor alloy, rather than being combined in a hybrid optical device. By a hybrid optical device it is to be understood a hybrid of active and passive devices or a hybrid of devices in different materials e.g. glass and semiconductor.

The known long period grating, or feature extraction filter, has a transmission characteristic in which the percentage of power transmitted is substantially linearly inversely proportional to the wavelength of incident light. For example, a transmission percentage varying from 10% to 90% in the range 1520 nm to 1560 nm in a substantially linear manner is useful for C-band operation. Variations of 5% to 95% have been achieved. This range is crucial to precision wavelength identification.

The output of the long period grating, or feature extraction filter, 110 may be optically connected by a second integrated waveguide 160 to the input of the Fabry Perot etalon 120 or to an external frequency locker. A second beam splitter 161 in the second integrated waveguide 160 deflects a proportion of light emergent from the long period grating, or feature extraction filter, 110 towards a second photodiode 163.

Instead of the long period grating, or feature extraction filter, filters of other types may be used. For example, a photonic band-gap crystal, with a slowly changing spectral response, may be utilized. Alternatively, a fibre optic coupler designed to separate two wavelength bands at 1480 nanometres and above is very suitable for C-band use, as such a coupler has an almost linear transmission power characteristic, decreasing with increasing wavelength. Such a coupler can be calibrated with a wavemeter and then used repeatedly without further accessing the wave-meter. In this embodiment, the long period grating, or feature extraction filter, is therefore omitted and replaced with a simple waveguide. Light from the waveguide passes through the fibre filter before reaching the second photodiode. Other possible filters are an optical fibre with an embedded diffraction grating or a coloured glass filter, for example, of a type used with NdYAG lasers.

Although, as described, the characterising functions are carried out from light emitted from a "rear" face of the laser, all these characterising functions can be carried out from the "front" power output face. This is particularly so in the case of a gain coupled sampled grating reflector (GCSR) laser, for example.

In order to characterise the laser it is necessary to find stable positions, remote from mode boundaries, where the laser will operate at a stable frequency without mode-hopping. Such stable points may be found on stable middle lines 143 halfway between super-mode boundaries 141,142, as shown in Figure 2.

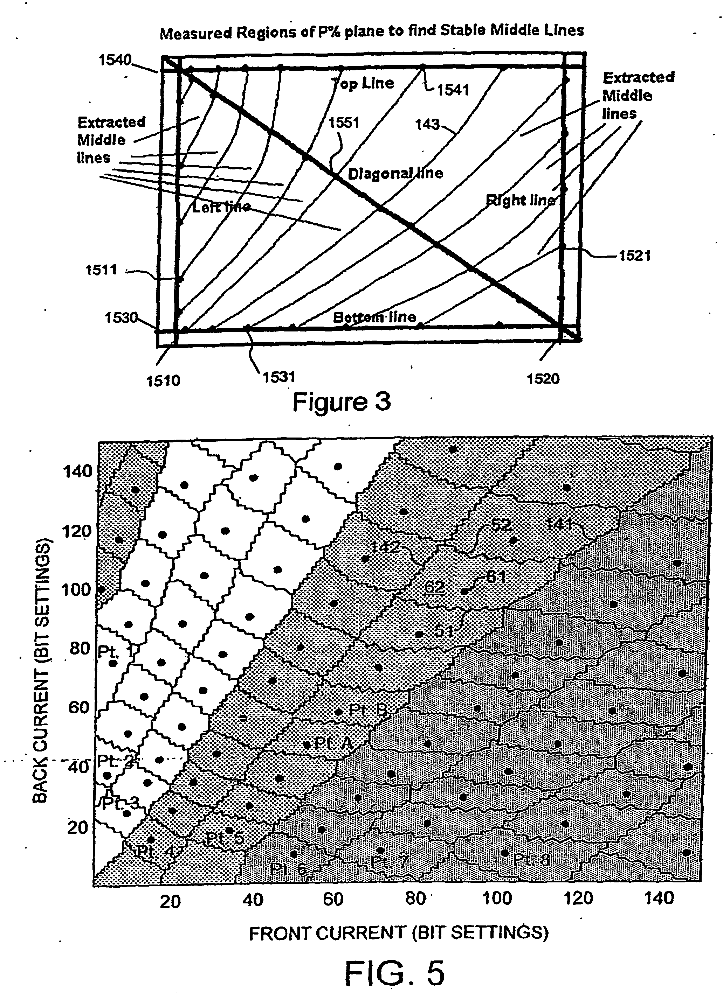

As disclosed in WO01/28052 and shown in Figure 3, the position of these stable lines can be obtained by sampling. Measurements are made in five stages along five or more lines of measurement as follows. The front current is held at a first constant value 1510 and the back current varied to determine stable points 1511 corresponding to intersections of stable middle lines with this first line of measurement. The front current is held constant at a second value 1520 and the back current varied along a second line of measurement to determine stable points 1521 representing points of intersections of the stable middle line with the second line of measurement. The back current is held constant at a third constant value 1530 and the front current is varied along a third line of measurement to determine stable points 1531 representing points of intersection of the stable middle lines with the third line of measurement. The back current is held constant at a fourth value 1540 and the front current is varied along a fourth line of measurement to determine stable points 1541 represented by an intersection of the stable middle line with the fourth line of measurement. The front current is increased from the first constant value 1510 to the second constant value 1520 while the back current is decreased from the fourth constant value 1540 to the third constant value 1530 along a fifth line of measurement to find points of intersection 1551 of the stable middle lines with the fifth line of measurement. Conveniently, the currents are varied by a fast programmed waveform with a frequency in the region of 100 kHz. With faster electronics it is anticipated that Megahertz frequencies may be used. Stable middle lines 143 can then be plotted by joining corresponding points of intersection on the respective lines of measurement as shown in Fig 3. To refine plotting of the stable middle lines, additional diagonal lines of measurement, parallel to the diagonal line of measurement shown in Fig 3, may be used. In an embodiment of the invention up to 100 diagonal lines of measurement may be used with pre-programmed waveforms rapidly to produce a mode map (see Figure 5) for visual inspection. In the case of GCSR lasers, in the fifth step, the front and back currents respectively may be varied between different constants, to accommodate a different orientation of the super-modes in GCSR lasers.

In this manner it is possible to plot a number of stable middle lines between super mode boundaries such as that shown in Fig 2. The stable operational points are then sought on these stable middle lines 143 midway between longitudinal mode boundaries 51,52 which transversely cross the stable middle lines 143 and the super-mode boundaries 141,142.

Moving along such a middle line and measuring the direct power for each point results in a plot such as that shown in Figure 4. The local minima 62 in the power output correspond with the longitudinal mode boundaries 51,52. The requirement then is to find the stable points 61 which are taken to be midway between two local minima 62 in the power output. To determine the local minima 62 a moving window may be used which has a fixed number of measurement points, for example, initially 10 points. The point, within the 10 points of the window, having a minimum power value is recorded and then the window moved by one point to determine the new point having a minimum power. A local minimum 62 is that point which returns a minimum value for each of 10 successive movements of the window. However, as can be seen from Figure 4, further along the middle line a wider window is required to encompass the wider arcs, up to 150 measurement points, for example.

Having established the local minima, the positions of the stable middle points 61 can be located as shown in Figure 4, being midway between local minima. As the position of the stable middle points are established they may be stored in a look-up table.

In this manner stable points 61 located between super-mode boundaries 141,142 and between longitudinal mode boundaries 51,52 may be identified as shown in Figure 5.

Operational conditions for operating at frequencies between the stable middle point frequencies are determined and stored in the look-up table. The required values of phase current injected into a phase section of the laser are determined by holding the back and front currents constant successively at a first stable point and incrementing the phase current until a frequency of laser emission corresponding to a next stable point is reached and calculating what increments of phase current are required to step from the first stable point to the second stable point in desired frequency increments.

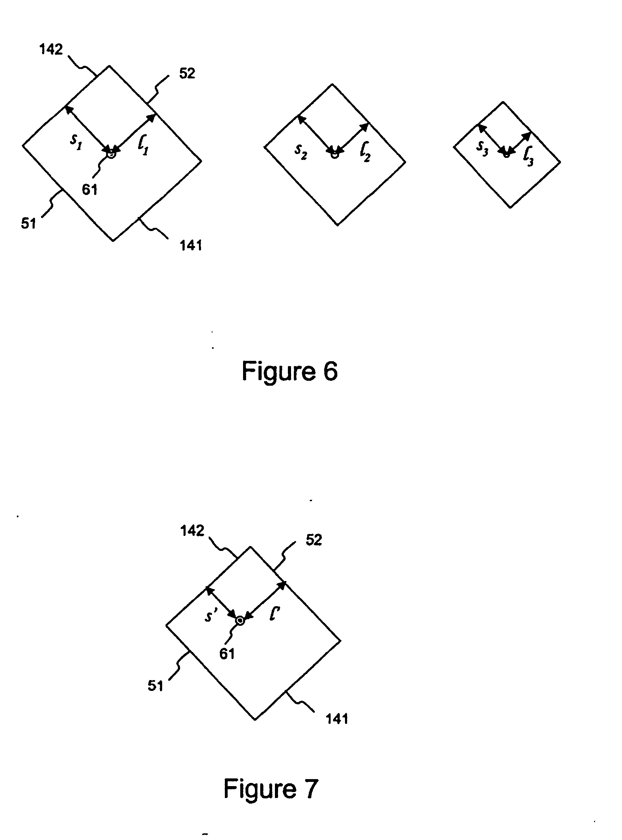

Referring to Figure 6, the present invention provides a method to produce stability factors, shown by double arrow-headed lines s,l, in relation to each of these stable points 61 respectively that indicate whether mode-hopping is likely or becoming more likely with ageing or other degradation. These stability factors s,1 measure the distance of the stable operating points from the mode boundaries 52,142 that characterize the laser behaviour when the tuning currents are incremented. The nearer the operating point 61 is to a mode boundary 52,142 the more likely that a mode hop is imminent thereby de-stabilizing the communication network.

The laser has two coarse-tuning electric currents, I_{F} and I_{B} (front and back grating sections for SGDBR lasers) or I_{G} and I_{C} (grating and coupler sections for GCSR lasers) and the laser power and wavelength are first characterized as a function of these two inputs as described above. This produces planes of data that are divided by mode boundaries 51,52,141,142 that must be avoided to prevent mode-hopping by the laser. The mode regions 62 between mode boundaries generated by the method disclosed in WO01/28052, and outlined above, have a distribution of sizes depicted schematically in Figure 6 with stable operating points 61 of the laser are at the centre of each region, having respective stability factors s₁, l₁; s₂, l₂, and s₃, l₃.

Stable middle points 61 inside the mode regions 62 have a range of implied "stability" as indicated by values s and 1, that is the distances of the stable points from the neighbouring super-mode boundaries 142 and longitudinal mode boundaries 52 respectively, or by their values when normalised to an average of the highest 10% of values giving S and L, each between 1.0 and 0.3 typically. Thus, a channel with L,S = 0.5,0.4 for example is less inherently "stable" than one with L,S = 0.9,0.8. Alternatively, some other suitable reference values of 1 and s representing a reticle of a reference size of mode region 62 may be used to normalise the values.

An extended LUT includes L,S for use as a quality control parameter for selection of excellent lasers and also to facilitate statistical analysis of a batch as well as for monitoring ageing of the lasers.

The monitoring method comprises a curtailed version of the look-up table generation procedure described above to check s and 1 values to ascertain whether ageing is causing the original "stability" to deteriorate.

The initial values for the stable points are determined during the processing stage illustrated in Figure 4. That is, having determined a position mid-way between two local minima, the distance 1 from the mid-way position, representing a stable point, and a local minima, representing a longitudinal mode boundary, is known.

The initial s values are determined, after the stable middle points are identified, by measuring a distance from a supermode boundary by biasing the front and back currents to drive the laser at the stable point and incrementing the front and back currents sufficiently to cross a supermode boundary. This is detected by a large change in wavelength and/or power emitted by the laser. Electronically this process may be implemented by subjecting the laser to a fast programmed current waveform using digital to analogue converter circuits.

The original LUT has the original or last-measured s and 1 values stored for comparison with the new values s,l' shown in Figure 7.

If after a period these values have changed significantly preventative action can be taken, for example, the laser may be re-characterised or replaced. A threshold change indicating that the laser has aged or otherwise deteriorated may be determined from a change in value exceeding a predetermined permitted change or a percentage change exceeding a predetermined permitted percentage change.

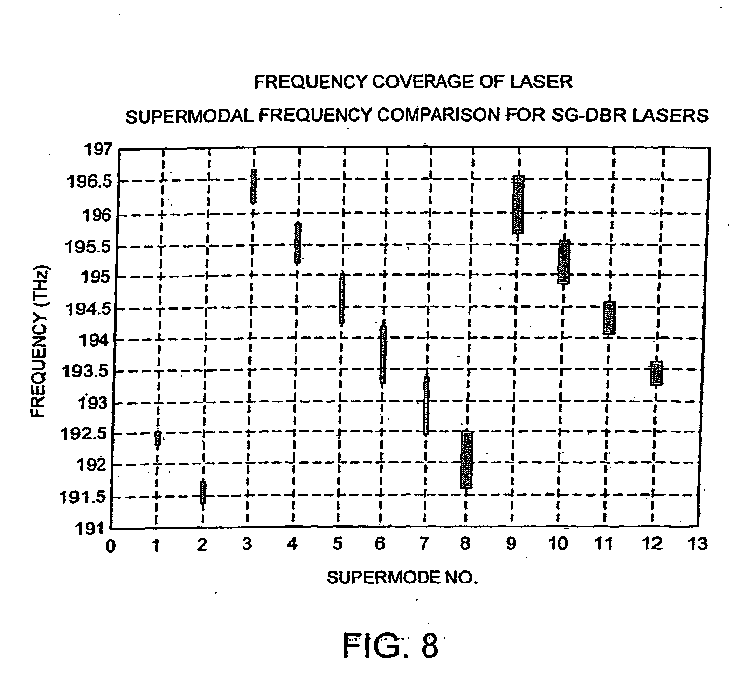

The monitoring method is a diminutive version of the full look-up table version of the invention. Referring to Figure 8, in which each of the frequency bars 81 indicates a frequency range emitted by the laser for a respective supennode number, after finding stable operating points for a laser chip away from mode boundaries, the laser chip is tested to ensure that all frequencies in a range of interest may be generated, as in the case shown in Figure 8. That is, taken together, all the frequency bars 81 cover the required frequency range, without any substantial frequency gaps. If all the frequencies cannot be generated, the chip fails the quality control monitoring test and is rejected, without proceeding to the generation of a look-up table for the laser. However, for chips which pass the quality control test, the look-up table is generated after the laser is packaged. Thus the use of a screen display of the frequency coverage of a laser on a chip, corresponding to Figure 8, provides an extremely fast quality test for laser chips.

It is found that monitoring the stability factors takes about 1 minute per laser, and this speed is ideally suited to a telecommunications application since with line terminal equipment per telecommunications optical fibre comprising 160 + 40 lasers, a full check may be carried out in only 200 minutes compared with 36 or more hours downtime required with alternative known schemes.

Alternatively, a single stable point may be located within a few milliseconds. It is anticipated that this may be achieved even faster with improved microcircuits.

The method comprises the use of a filter as described in WO01/28052, along with current input and power and wavelength output data acquisition circuits, DAQs. While the LUT is being generated the stability factors are also gathered and stored. These can be periodically checked using the stable middle lines 143, Figure 3, for the laser by applying programmed electronic waveforms.

## Claims

1. A method of characterising a tuneable multi-section semiconductor laser (100) comprising the steps of a) applying currents in step-wise increments to sections of the laser respectively; b) measuring power output by the laser to determine values of the applied currents corresponding to respective stable operating conditions (61) for which the laser emits radiation at wavelengths remote from mode boundaries of the laser; c) determining the respective wavelength of the emitted radiation; d) measuring variations in the applied currents required to cross a mode boundary (52, 142) such that the laser emits at a wavelength different from that under the respective stable operating condition; and e) storing in a look-up table respective values of applied currents for which the laser emits radiation at wavelengths remote from mode boundaries, the corresponding wavelengths of the radiation and the variations in applied currents required to cross adjacent mode boundaries.

2. A method as claimed in claim 1, wherein step a) comprises applying currents in step-wise increments using a programmed waveform.

3. A method as claimed in claims 1 or 2, wherein the programmed waveform has a frequency of 100 kHz.

4. , A method as claimed in claims 1 or 2, wherein the programmed waveform has a frequency of 1MHz.

5. A method as claimed in any of the preceding claims, wherein step d) of measuring the variations comprises deriving the variations by determining distances (s,l) in an applied current plane of a point (61) corresponding to the stable operating condition from adjacent longitudinal and super-mode boundaries (52, 142).

6. A method as claimed in any of the preceding claims, wherein the stored variations (s,l) are normalised.

7. A method as claimed in any of the preceding claims, wherein the multi-section semiconductor laser has front, gain, phase and back sections and step a) includes the steps of a1) applying constant currents to the gain and phase sections such that the laser emits laser radiation; a2) applying back and front currents in step-wise increments to the back and front sections respectively; and step e) includes storing in a look-up table the values of front and back current for which the laser emits radiation at wavelengths remote from mode boundaries.

8. A method as claimed in claim 7, wherein step c) includes step c1) providing an optical filter (110) for transmitting a proportion of power of an incident light beam emitted by the laser, the proportion being dependant on the wavelength of the incident light beam; and step c2) measuring the proportion of power transmitted by the filter to determine the wavelength of the emitted radiation.

9. A method as claimed in claim 7 or 8, wherein step a) comprises holding the front current at a first front constant (1510) and varying the back current, holding the front current at a second front constant (1520) and varying the back current, holding the back current at a first back constant (1530) and varying the front current, holding the back current at a second back constant (1540) and varying the front current, and increasing the front current from a third front constant to a fourth front constant while decreasing the back current from a third back constant to a fourth back constant, thereby defining a first diagonal line of measurement, in order to determine stable middle lines within each super-mode and wherein, having determined the stable middle lines (143), subsequent steps of varying the back current and/or the front current respectively comprise varying the respective current through a window of a plurality of incremental values along the stable middle lines and determining for which of the plurality of incremental values the power output is a minimum (62), and repeatedly incrementing each of the plurality of incremental values and re-determining the current value corresponding to the minimum output power within the window to determine a current value corresponding to a local minimum in the power output.

10. A method as claimed in claim 9, including the further step of increasing the front current and decreasing the back current to determine further stable points along further diagonal lines of measurement parallel to the first diagonal line of measurement to generate a mode map for display on a visual display.

11. A method as claimed in any of claims 7 to 10, wherein step b) comprises determining midpoints between the current values corresponding to local minima (62) in the power output to obtain stable middle points (61) of operation of the laser and step e) includes storing data representative of such stable middle points together with the corresponding wavelength of emitted laser light in the look-up table and wherein operational conditions arranged for operating the frequencies between the stable middle point frequencies are determined by determining and storing in the look-up table the required values of phase current injected into the phase section of the laser and wherein the required values of phase current are determined by holding the back and front currents constant successively at a first stable point and incrementing the phase current until a frequency of laser emission corresponding to a next stable point is reached and calculating what increments of phase current are required to step from frequency of the first stable point to the frequency of the second stable point in desired frequency increments.

12. A method as claimed in any of the preceding claims comprising the further step of f) measuring the variations in the applied currents at predetermined intervals of time to determine new values of the variations; and g) comparing the new values with previously determined values of the variations to determine whether any change in the values is sufficient to require re-characterisation of the laser.

13. A method as claimed in claim 12, wherein step g) comprises comparing the new values with values stored in the look-up table when the laser was last characterised.

14. A method as claimed in claim 12 wherein the step of determining whether any change in the values is sufficient to require re-characterisation of the laser comprises determining whether the variations are greater than a predetermined value or represent more than a predetermined percentage change.

## Patentansprüche

1. Verfahren zur Kennzeichnung eines abstimmbaren mehrteiligen Halbleiterlasers (100), wobei das Verfahren die folgenden Schritte umfass: a) das Zuführen von Strömen in stufenweisen Schritten an die entsprechenden Abschnitte des Lasers; b) das Messen der Energieleistung des Lasers zur Bestimmung von Werten der zugeführten Ströme gemäß entsprechenden stabilen Betriebsbedingungen (61), in Bezug auf welche der Laser Strahlung in von den Modusgrenzen des Lasers entfernten Wellenlängen emittiert; c) das Bestimmen der entsprechenden Wellenlänge der emittierten Strahlung; d) das Messen von Schwankungen der angelegten Ströme, die zur Überschreibung einer Modusgrenze (52, 142) erforderlich sind, so dass der Laser mit einer Wellenlänge emittiert, die sich von der Wellenlänge unter dem entsprechenden stabilen Betriebszustand unterscheidet; und e) das Speichern entsprechender Werte der zugeordneten Ströme in einer Verweistabelle, in Bezug auf welche der Laser Strahlung auf von den Modusgrenzen entfernten Wellenlängen emittiert, wobei die entsprechenden Strahlungswellenlängen und die Schwankungen der zugeführten Ströme zur Überschreitung benachbarter Modusgrenzen erforderlich sind.

2. Verfahren nach Anspruch 1, wobei der Schritt a) das Zuführen von Strömen in stufenweisen Schritten unter Verwendung einer programmierten Kurvenform umfasst.

3. Verfahren nach Anspruch 1 oder 2, wobei die programmierte Kurvenform eine Frequenz von 100 kHz aufweist.

4. Verfahren nach Anspruch 1 oder 2, wobei die programmierte Kurvenform eine Frequenz von 1 MHz aufweist.

5. Verfahren nach einem der vorstehenden Ansprüche, wobei der Schritt d) des Messens der Schwankungen das Ableiten der Schwankungen durch das Bestimmen von Entfernungen (s,l) in einer zugeführten Stromebene eines Punktes (61) umfasst, der einem stabilen Betriebszustand entspricht, und zwar aus benachbarten longitudinalen und Supermodus-Grenzen (52, 142).

6. Verfahren nach einem der vorstehenden Ansprüche, wobei die gespeicherten Schwankungen (s,l) normalisiert werden.

7. Verfahren nach einem der vorstehenden Ansprüche, wobei der mehrteilige Halbleiterlaser vordere, Verstärkungs-, Phasen- und hintere Abschnitte aufweist, und wobei der Schritt a) die folgenden Schritte aufweist: a1) das Zuführen konstanter Ströme an die Verstärkungs- und Phasenabschnitte, so dass der Laser Laserstrahlung emittiert; a2) das Zuführen hinterer und vorderer Ströme in stufenweisen Schritten an die entsprechenden hinteren und vorderen Abschnitte; und wobei der Schritt e) das Speichern der Werte des vorderen und des hinteren Stroms in einer Verweistabelle umfasst, in Bezug auf welche der Laser Strahlung in von den Modusgrenzen entfernten Wellenlängen emittiert.

8. Verfahren nach Anspruch 7, wobei der Schritt c) die folgenden Schritte umfasst: c1) das Bereitstellen eines optischen Filters (110) zum Übertragen eines Anteils der Leistung eines durch den Laser emittierten einfallenden Lichtstrahls, wobei der Anteil von der Wellenlänge des einfallenden Lichtstrahls abhängig ist; und c2) das Messen des Anteils der durch den Filter übertragenen Leistung, um die Wellenlänge der emittierten Strahlung zu bestimmen.

9. Verfahren nach Anspruch 7 oder 8, wobei der Schritt a) das Halten des vorderen Stroms auf einer ersten vorderen Konstante (1510) und das Anpassen des hinteren Stroms umfasst, das Halten des vorderen Stroms auf einer zweiten vorderen Konstante (1520) und das Anpassen des hinteren Stroms, das Halten des hinteren Stroms auf einer ersten hinteren Konstante (1530) und das Anpassen des vorderen Stroms, das Halten des hinteren Stroms auf einer zweiten hinteren Konstante (1540) und das Anpassen des vorderen Stroms; und das Erhöhen des vorderen Stroms von einer dritten vorderen Konstante auf eine vierte vordere Konstante, während der hintere Strom von einer dritten hinteren Konstante auf eine vierte hintere Konstante verringert wird, wodurch eine erste diagonale Messlinie definiert wird, um stabile Mittellinien in jedem Supermodus zu bestimmen, und wobei nach der Bestimmung der stabilen Mittellinien (143) folgende Schritt des entsprechenden Anpassens des hinteren Stroms und/oder des vorderen Stroms das Anpassen des entsprechenden Stroms innerhalb eines Fensters einer Mehrzahl inkrementaler Werte entlang der stabilen Mittellinien umfassen sowie das Bestimmen, für welchen der Mehrzahl inkrementaler Werte die Energieleistung einem Minimum (62) entspricht, sowie das wiederholte Inkrementieren jedes der Mehrzahl inkrementaler Werte und das erneute Bestimmen eines Stromwerts, welcher der Mindestenergieleistung innerhalb des Fensters entspricht, um einen Stromwert zu bestimmen, der einem lokalen Minimum der Energieleistung entspricht.

10. Verfahren nach Anspruch 9, wobei das Verfahren ferner den Schritt des Erhöhens des vorderen Stroms und des Verringerns des hinteren Stroms aufweist, um weitere stabile Punkte entlang weiterer diagonaler Messlinien zu bestimmen, die parallel zu der ersten diagonalen Messlinie sind, so dass eine Modusabbildung zur Anzeige auf einer Sichtanzeige erzeugt wird.

11. Verfahren nach einem der Ansprüche 7 bis 10, wobei der Schritt b) das Bestimmen von Mittelpunkten zwischen den Stromwerten umfasst, die lokalen Minima (62) in der Energieleistung entsprechen, um stabile Mittelpunkte (61) für den Betrieb des Lasers zu erhalten, und wobei der Schritt e) das Speichern von Daten aufweist, die diese stabilen Mittelpunkte gemeinsam mit der entsprechenden Wellenlänge des emittierten Laserlichts in der Verweistabelle darstellen, und wobei Betriebsbedingungen, die für den Betrieb der Frequenzen zwischen den stabilen Mittelpunktfrequenzen angeordnet sind, bestimmt werden durch die Bestimmung und das Speichern der erforderlichen Werte des in den Phasenabschnitt des Lasers injizierten Phasenstroms in der Verweistabelle, und wobei die erforderlichen Werte des Phasenstroms bestimmt werden, indem die hinteren und vorderen Ströme aufeinanderfolgend an einem ersten stabilen Punkt konstant gehalten werden und durch Inkrementieren des Phasenstroms, bis eine Frequenz der Laseremission, die einem nächsten stabilen Punkt entspricht, erreicht worden ist, und Berechnen, welche Inkremente des Phasenstroms erforderlich sind, um von der Frequenz des ersten stabilen Punkts zu der Frequenz des zweiten stabilen Punkts in gewünschten Frequenzschritten zu wechseln.

12. Verfahren nach einem der vorstehenden Ansprüche, wobei das Verfahren die folgenden weiteren Schritte umfasst: f) das Messen der Schwankungen der zugeführten Ströme in vorbestimmten Zeitintervallen, um neue Werte für die Schwankungen zu bestimmen; und g) das Vergleichen der neuen Werte mit vorher bestimmten Werten der Anpassungen, um zu bestimmen, ob eine Änderung der Werte ausreicht, um eine neue Kennzeichnung des Lasers erforderlich zu machen.

13. Verfahren nach Anspruch 12, wobei der Schritt g) das Vergleichen der neuen Werte mit in der Verweistabelle gespeicherten Werten umfasst, wenn der Laser zuletzt gekennzeichnet worden ist.

14. Verfahren nach Anspruch 12, wobei der Schritt des Bestimmens, ob eine Änderung der Werte ausreicht, um eine neue Kennzeichnung des Lasers erforderlich zu machen, das Bestimmen umfasst, ob die Schwankungen größer sind als ein vorbestimmter Wert oder ob sie mehr als eine vorbestimmte prozentuale Veränderung darstellen.

## Revendications

1. Procédé de caractérisation d'un laser à semi-conducteurs multisections accordables (100) comprenant les étapes consistant à a) appliquer des courants dans des incréments successifs aux sections du laser respectivement ; b) mesurer la puissance émise par le laser pour déterminer les valeurs des courants appliqués correspondant à des conditions de fonctionnement stables respectives (61) pour lesquelles le laser émet un rayonnement à des longueurs d'onde éloignées des frontières de mode du laser ; c) déterminer la longueur d'onde respective du rayonnement émis ; d) mesurer les variations dans les courants appliqués requis pour traverser une frontière de mode (52, 142), afin que le laser émette à une longueur d'onde différente de celle dans la condition de fonctionnement stable respective ; et e) stocker dans une table de recherche les valeurs respectives des courants appliqués pour lesquels le laser émet un rayonnement à des longueurs d'onde éloignées des frontières de mode, les longueurs d'onde correspondantes du rayonnement et les variations dans les courants appliqués requis pour traverser les frontières de mode adjacentes.

2. Procédé selon la revendication 1, dans lequel l'étape a) comprend l'étape consistant à appliquer les courants dans des incréments successifs en utilisant une forme d'onde programmée.

3. Procédé selon la revendication 1 ou 2, dans lequel la forme d'onde programmée a une fréquence de 100 kHz.

4. Procédé selon la revendication 1 ou 2, dans lequel la forme d'onde programmée a une fréquence de 1 MHz.

5. Procédé selon l'une quelconque des revendications précédentes, dans lequel l'étape d) de mesure des variations comprend l'étape consistant à dériver les variations en déterminant les distances (s, l)dans un plan de courant appliqué d'un point (61) correspondant à la condition de fonctionnement stable à partir de frontières longitudinale stable et super-mode (52, 142).

6. Procédé selon l'une quelconque des revendications précédentes, dans lequel les variations stockées (s, l) sont normalisées.

7. Procédé selon l'une quelconque des revendications précédentes, dans lequel le laser à semi-conducteurs multisections a des sections avant, de gain, de phase et arrière et l'étape a) comprend les étapes consistant à a1) appliquer des courants constants aux sections de gain et de phase afin que le laser émette un rayonnement laser ; a2) appliquer des courants arrière et avant dans des incréments successifs sur les sections arrière et avant respectivement ; et l'étape e) comprend l'étape consistant à stocker dans une table de recherche les valeurs du courant avant et arrière pour lesquelles le laser émet un rayonnement à des longueurs d'onde éloignées des frontières de mode.

8. Procédé selon la revendication 7, dans lequel l'étape c) comprend l'étape c1) consistant à fournir un filtre optique (110) pour transmettre une proportion de puissance d'un rayon de lumière incidente par le laser, la proportion dépendant de la longueur d'onde du rayon de lumière incidente ; et l'étape c2) consistant à mesurer la proportion de puissance transmise par le filtre pour déterminer la longueur d'onde du rayonnement émis.

9. Procédé selon la revendication 7 ou 8, dans lequel l'étape a) comprend l'étape consistant à tenir le courant avant à une première constante avant (1510) et à varier le courant arrière, à tenir le courant avant à une deuxième constante avant (1520) et à varier le courant arrière, à tenir le courant arrière à une première constante arrière (1530) et à varier le courant avant, à tenir le courant arrière à une deuxième constante arrière (1540) et à varier le courant avant, et à augmenter le courant avant d'une troisième constante avant à une quatrième constant avant tout en diminuant le courant arrière d'une troisième constante arrière à une quatrième constante arrière, définissant ainsi une première ligne diagonale de mesure, afin de déterminer des lignes moyennes stables à l'intérieur de chaque super-mode et dans lequel, après avoir déterminé les lignes moyennes stables (143), les étapes subséquentes de variation du courant arrière et/ou du courant avant respectivement comprennent l'étape consistant à varier le courant respectif à travers une fenêtre d'une pluralité de valeurs incrémentielles le long des lignes moyennes stables et à déterminer pour laquelle de la pluralité des valeurs incrémentielles la puissance émise est un minimum (62), et à incrémenter de manière répétée chacune de la pluralité de valeurs incrémentielles et à re-déterminer la valeur de courant correspondant à la puissance émise minimale à l'intérieur de la fenêtre pour déterminer une valeur de courant correspondant à un minimum local dans la puissance émise.

10. Procédé selon la revendication 9, comprenant en outre l'étape consistant à augmenter le courant avant et à diminuer le courant arrière pour déterminer d'autres points stables le long d'autres lignes diagonales de mesure parallèles à la première ligne diagonale de mesure pour générer une carte de mode à afficher sur un affichage visuel.

11. Procédé selon l'une quelconque des revendications 7 à 10, dans lequel l'étape b) comprend l'étape consistant à déterminer des points centraux entre les valeurs de courant correspondant à des minima locaux (62) dans la puissance émise pour obtenir des points centraux stables (61) de fonctionnement du laser et l'étape e) comprend l'étape consistant à stocker des données représentatives de ces points centraux stables avec la longueur d'onde correspondante de lumière laser émise dans la table de recherche et dans lequel les conditions opérationnelles agencées pour utiliser les fréquences entre les fréquences de point central stable sont déterminées en déterminant et en stockant dans la table de recherche les valeurs requises de courant de phase injecté dans la section de phase du laser et dans lequel les valeurs requises de courant de phase sont déterminées en tenant la constante de courant arrière et avant successivement à un premier point stable et en augmentant le courant de phase jusqu'à ce qu'une fréquence d'émission laser correspondant à un point stable suivant soit atteinte et en calculant quels incréments de courant de phase sont requis pour passer de la fréquence du premier point stable à la fréquence du second point stable dans des incréments de fréquence souhaités.

12. Procédé selon l'une quelconque des revendications précédentes comprenant en outre les étapes consistant à f) mesurer les variations dans les courants appliqués à des intervalles de temps prédéterminés pour déterminer de nouvelles valeurs des variations ; et g) comparer les nouvelles valeurs aux valeurs précédemment déterminées des variations pour déterminer si un changement dans les valeurs est suffisant pour nécessiter la re-caractérisation du laser.

13. Procédé selon la revendication 12, dans lequel l'étape g) comprend l'étape consistant à comparer les nouvelles valeurs à des valeurs stockées dans la table de recherche lorsque le laser a été caractérisé pour la dernière fois.

14. Procédé selon la revendication 12 dans lequel l'étape consistant à déterminer si un changement dans les valeurs suffit pour nécessiter la re-caractérisation du laser comprend l'étape consistant à déterminer si les variations sont supérieures à une valeur prédéterminée ou représentent plus d'un changement de pourcentage prédéterminé.
